# DEMANDE DE BREVET EUROPEEN

(11) **EP 1 220 122 A1**
(43) Date de publication de la demande: **03.07.2002**
(21) Numéro de dépôt: 01205010.0
(22) Date de dépôt: 19.12.2001
(51) Int. Cl.: G06F 17/50

(54) **Procédé d'optimisation de performances temporelles à convergence rapide.**

(30) Priorité: 28.12.2000 FR 0017210
(71) Demandeur: Koninklijke Philips Electronics N.V., 5621 BA Eindhoven (NL)
(72) Inventeur: Giaume, Olivier, Société Civile S.P.I.D., 75008 Paris (FR); Brochier, Béatrice, Société Civile S.P.I.D., 75008 Paris (FR); Alves, Philippe, Société Civile S.P.I.D., 75008 Paris (FR); Faucon Christelle, Société Civile S.P.I.D., 75008 Paris (FR)
(74) Mandataire: Landousy, Christian

(57) **Abrégé**

La présente invention concerne un procédé d'optimisation de performances temporelles d'un réseau de cellules électroniques, comprenant une pluralité de cellules prélevées au sein d'une librairie (LIB) comportant plusieurs catégories de cellules, les cellules d'une même catégorie ayant toutes une même fonctionnalité.

Le procédé selon l'invention inclut les étapes suivantes :
. calcul précis de temps de propagation (dt) de signaux transitant au travers de chaque cellule du réseau, et
. identification de cellules ayant une valeur du temps de propagation calculé (dti) supérieure à une valeur de référence (Ref)prédéterminée.

Application : Conception de circuits de traitement du signal pour radiotéléphones.

## Description

### Domaine de l'invention

La présente invention concerne un procédé d'optimisation de performances temporelles d'un réseau de cellules électroniques, comprenant une pluralité de cellules prélevées au sein d'une bibliothèque comportant plusieurs catégories de cellules, les cellules d'une même catégorie ayant toutes une même fonctionnalité.

De tels procédés sont couramment utilisés dans l'industrie microélectronique pour la mise au point de circuits intégrés. Afin de rendre un circuit intégré capable de traiter rapidement d'importants volumes de données, il est en effet nécessaire de minimiser autant que possible les temps de propagation de signaux parcourant ledit circuit.

### Arrière plan technologique

La plupart des procédés d'optimisation connus requièrent une identification d'au moins un chemin critique, qui est usuellement constitué par le plus long trajet existant entre deux cellules mémoire. Le temps nécessaire à un signal pour parcourir ce trajet détermine une fréquence maximale pour des signaux d'horloge destinés à cadencer les cellules mémoire délimitant le chemin critique, et définit ainsi la fréquence de fonctionnement du circuit intégré, et par conséquent un débit de données que ledit circuit est capable de traiter. Une réduction du temps de trajet correspondant au chemin critique permet donc une augmentation de la valeur maximale de ce débit. Un tel procédé d'optimisation opérant l'identification de chemins critiques est notamment décrit dans le brevet US No. 5,872,717. La mise en oeuvre d'un tel procédé d'optimisation présente un certain nombre d'inconvénients.
Tout d'abord, l'identification d'un chemin critique ne peut être effectuée qu'au prix d'une analyse temporelle de l'ensemble des interconnexions entre les cellules composant le réseau, ce qui nécessite un temps de calcul considérable, du fait du volume des informations à prendre en compte. De plus, pour un nombre constant de cellules incluses dans le réseau, la valeur de ce temps de calcul sera d'autant plus importante que la complexité des interconnexions sera grande. Il est donc difficile de prédire la durée nécessaire à l'identification des chemins critiques requise par les procédés d'optimisation connus.
Le procédé connu prévoit en outre de redimensionner certaines cellules intervenant le long du chemin critique identifié, de manière à réduire le temps de trajet correspondant. Cependant, lesdites cellules peuvent intervenir dans d'autres chemins de données qui n'auront pas été pris en considération, et le fait de modifier ces cellules peut augmenter la durée de ces autres trajets et donner naissance à de nouveaux chemins critiques. Il est donc nécessaire de procéder, après chaque redimensionnement, à une nouvelle identification de chemins critiques du réseau de cellules modifié, et de remplacer si besoin est d'autres cellules intervenant dans les nouveaux chemins critiques ainsi identifiés.
On comprend qu'un grand nombre d'itérations peut être nécessaire avant de converger vers un réseau qui ne contiendra que des chemins critiques présentant des temps de trajet acceptables au vu d'un cahier des charges régissant les performances temporelles du circuit intégré. Il est par ailleurs possible qu'une telle convergence ne puisse jamais être atteinte.

Il ressort clairement de ce qui précède que les procédés d'optimisation connus, basés sur une identification de chemins critiques, présentent un coût de mise en oeuvre important et non-prédictible, et peuvent se révéler inefficaces.

L'invention a pour but de remédier à ces inconvénients en proposant un procédé d'optimisation de performances temporelles qui ne nécessite pas d'identification ou de modification spécifiques de chemins critiques du réseau de cellules.

### Résumé de l'invention

En effet, selon l'invention, un procédé d'optimisation conforme au paragraphe introductif inclut les étapes suivantes :
. calcul précis de temps de propagation de signaux transitant au travers de chaque cellule du réseau, et
. identification de cellules ayant une valeur du temps de propagation calculé supérieure à une valeur de référence prédéterminée.

Le procédé selon l'invention analyse en une seule fois le comportement de chaque cellule incluse dans le réseau, indépendamment de ses connexions avec les autres cellules du réseau. La durée de cette analyse est donc indépendante de la complexité des interconnexions entre les cellules du réseau, et ne dépend que du nombre total de cellules.
Par ailleurs, toutes les cellules du réseau qui présentent un temps de propagation trop important peuvent être simultanément remplacées par des cellules plus puissantes, et donc plus rapides. Ceci fait disparaître les risques liés à des modifications locales tendant à perturber d'autres portions du réseau, et limite considérablement le nombre d'itérations nécessaires à l'obtention de chemins critiques de durée acceptable. En pratique, si la valeur de référence est bien choisie, une seule itération sera nécessaire et une convergence immédiate pourra alors être obtenue.

Selon un mode de mise en oeuvre de l'invention, une valeur de seuil prédéterminée valⱼ est attribuée à chaque cellule de rang j d'une même catégorie, et, lorsqu'une cellule de rang i identifiée doit être remplacée par une cellule de rang supérieur k, la valeur de k est au moins égale à i+j si la valeur du temps de propagation calculé pour ladite cellule de rang i est supérieure à la valeur de seuil prédéterminée valⱼ de la cellule de rang j.

Ce mode de mise en oeuvre de l'invention permet d'assurer qu'une cellule de remplacement destinée à être substituée à une cellule identifiée comme trop peu puissante, puisque la valeur de son temps de propagation calculé est supérieure à la valeur de référence, aura une puissance suffisante pour que le temps de propagation de ladite cellule de remplacement soit inférieur à la valeur de référence, ce qui contribue à augmenter la rapidité de la convergence évoquée plus haut.

Selon un mode de mise en oeuvre particulier de l'invention, lorsqu'une cellule de rang i identifiée doit être remplacée par une cellule de rang supérieur k, la valeur de k est égale à i+j si la valeur du temps de propagation calculé pour ladite cellule de rang i est comprise entre les valeurs de seuil prédéterminées valⱼ et valⱼ₊₁ des cellules de rangs consécutifs j et j+1.

Ce mode de mise en oeuvre permet d'assurer que la puissance de la cellule de remplacement est juste suffisante pour que son temps de propagation calculé soit inférieur à la valeur de référence.
Un remplacement d'une cellule trop lente par une cellule plus rapide se traduit en pratique le plus souvent par une augmentation de la taille de ladite cellule, ce qui est en soi une conséquence néfaste, puisqu'elle provoque un accroissement de l'encombrement du réseau de cellules et donc de son coût de fabrication. Le mode de mise en oeuvre particulier de l'invention décrit ci-dessus permet de réduire l'ampleur des effets néfastes découlant de l'opération de remplacement, en limitant l'augmentation de la taille de la cellule à ce qui est strictement nécessaire pour qu'elle présente un temps de propagation acceptable.

Selon une variante de l'invention, l'exécution de l'étape de remplacement est assujettie à une validation de la part d'un utilisateur du procédé d'optimisation.

Cette variante permet à l'utilisateur de sélectionner celles des cellules qu'il souhaite remplacer, et donc de maîtriser l'accroissement de l'encombrement du réseau résultant de la mise en oeuvre du procédé d'optimisation.

L'invention concerne également, dans son application la plus immédiate, un circuit intégré incluant un réseau de cellules dont les performances temporelles ont été optimisées au moyen d'un procédé tel que décrit plus haut.

Enfin, dans une de ses applications, l'invention concerne en outre un appareil récepteur de signaux radioélectriques incluant un tel circuit intégré.

### Brève description des figures

L'invention sera mieux comprise à l'aide de la description suivante, faite à titre d'exemple non-limitatif et en regard des dessins annexés, dans lesquels :
- la figure 1 est un organigramme décrivant un procédé d'optimisation conforme à un mode de mise en oeuvre l'invention,
- la figure 2 est un schéma permettant de visualiser les effets d'un tel procédé sur la structure d'un réseau de cellules,
- la figure 3 est un schéma illustrant une application possible d'un circuit intégré incluant un tel réseau de cellules, et
- la figure 4 illustre un exemple de remplacement de cellules selon le procédé d'optimisation de la figure 1.

### Détail de la description de l'invention

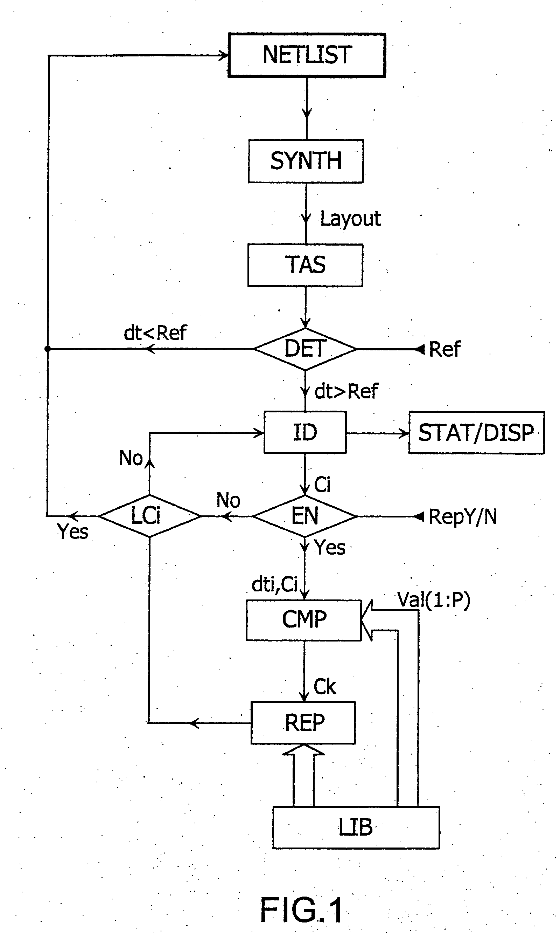

La figure 1 représente schématiquement une chaîne méthodologique permettant de générer des masques représentatifs de la topographie d'un circuit intégré, chaîne dans laquelle un procédé conforme à l'invention est mis en oeuvre.
Au cours d'une première étape, un utilisateur de la chaîne, qui sera le plus souvent un concepteur de circuits intégrés, élabore une liste d'interconnexions NETLIST, qui inclut des définitions de chacune des cellules composant le réseau, ainsi qu'une description des connexions d'entrées et de sorties propres à chaque cellule. Dans la plupart des applications, les cellules seront des portes logiques dont des modèles sont répertoriés dans une librairie de cellules LIB. Cette librairie contient plusieurs catégories de cellules, les cellules d'une même catégorie ayant toutes une même fonctionnalité et étant préférentiellement ordonnées par ordre de puissance croissante.
Au cours d'une étape de synthèse SYNTH, l'utilisateur exécute un programme de synthèse qui, sur la base de la liste d'interconnexions, génère un dessin Layout de la topographie du réseau de cellules.
Au cours d'une étape d'analyse temporelle TAS, un programme de calcul calcule précisément des temps de propagation dt de signaux transitant au travers de chaque cellule du réseau. A cet effet, ledit programme se base sur un fichier source couramment appelé SPEF « Standard Parasitic Extraction Format » comportant des paramètres physiques tels que des capacités ou des résistances. Les paramètres physiques sont issus d'un masque représentant physiquement le circuit, ledit masque étant conçu lors d'une étape connue de placement routage de cellules appelées dans la langue anglaise « Back-End ». Le programme de calcul extrait un fichier final au format standard SDF « Standard Delay Format » contenant lesdits temps de propagation calculés.
On notera qu'en calculant de façon précise le temps de propagation dt pour chaque cellule, on évite d'avoir une marge d'erreur importante sur ce temps à la fin du traitement des cellules et notamment lors de remplacement de certaines cellules. Cela évite ainsi d'effectuer un grand nombre d'itérations et par suite cela évite de diverger par rapport au réseau que l'on veut obtenir.
De tels programmes de synthèse et de calcul sont des outils logiciels courants, disponibles sur le marché des logiciels d'aide à la conception de circuits intégrés.
Au cours d'une étape de détection DET, chaque valeur de temps de propagation calculée dt est comparée à une valeur de référence Ref prédéterminée par l'utilisateur. Si aucune valeur de temps de propagation calculé dt n'est supérieure à la valeur de référence Ref, cela signifie que les performances temporelles du réseau de cellules défini par la liste d'interconnexions NETLIST sont acceptables pour l'utilisateur au vu d'un cahier des charges que le circuit intégré qu'il conçoit doit respecter. La liste d'interconnexions NETLIST est alors validée sans qu'il soit nécessaire de la modifier. Si, au contraire, certaines valeurs de temps de propagation calculé dt sont supérieures à la valeur de référence Ref, cela signifie que les cellules correspondantes doivent en principe être remplacées par des cellules de même fonctionnalité plus puissantes, présentant des temps de propagation plus courts.
Ces cellules sont identifiées au cours d'une étape d'identification ID, et, dans le mode de mise en oeuvre particulier de l'invention décrit ici, une étape d'affichage STAT/DISP informe l'utilisateur de l'existence de telles cellules candidates au remplacement. En pratique, l'affichage lui-même pourra prendre des formes diverses, comme par exemple une liste des cellules candidates, leur localisation physique dans la topographie Layout, et/ou des données statistiques comme le rapport entre le nombre de cellules candidates au remplacement et le nombre total de cellules incluses dans le réseau, ou encore un rapport entre les surfaces correspondantes.
Dans ce mode de mise en oeuvre de l'invention, une étape de validation EN assujettit l'exécution des remplacements à une validation de la part de l'utilisateur, qui, au moyen d'un message RepY/N, détermine si une cellule candidate doit ou non être remplacée. Cette validation pourra être faite au cas par cas, mais on pourra également prévoir de laisser à l'utilisateur la possibilité de déterminer simplement un pourcentage du nombre de cellules candidates à remplacer effectivement, par exemple un pourcentage de 5%, le choix des cellules à remplacer pouvant alors être fait de manière aléatoire par le procédé d'optimisation. Ainsi, le choix du pourcentage de cellules à modifier, et notamment en prenant un pourcentage petit par rapport au nombre de cellules existant, permet de modifier lesdites cellules très rapidement sans erreur lors de l'étape de placement routage, une modification de cellules étant couramment appelée ECO « Engineering Change Order ».
Dans l'exemple décrit ici, le remplacement effectif de chaque cellule candidate, dont l'identité Ci a été mémorisée au cours de l'étape d'identification ID, nécessite une validation de la part de l'utilisateur. Si ce dernier choisit de ne modifier aucune cellule, ou de ne pas modifier la dernière cellule candidate, notée LCi, la liste d'interconnexions NETLIST est validée dans son dernier état. Le remplacement d'une cellule candidate Ci est effectué comme suit :
Au cours d'une étape de comparaison CMP, le temps de propagation calculé dti de la cellule candidate Ci est comparé à des valeurs de seuil prédéterminées valⱼ attribuées à diverses cellules Cj, appartenant à la même catégorie que la cellule candidate Ci, présentes dans la librairie LIB. Préférentiellement, il existe 4 valeurs de seuil valj.

Ces valeurs valⱼ sont des grandeurs temporelles et sont croissantes en fonction du rang des cellules Cj. Elles sont émises par la librairie LIB, qui est donc configurable, sous forme d'un mot Val(1:P) dans cet exemple, ce qui signifie que chaque catégorie comporte P cellules de même fonctionnalité ordonnées par ordre de puissance croissante de 1 jusqu'à P. A l'issue de l'étape de comparaison CMP, le rang k d'une cellule Ck destinée à remplacer la cellule candidate Ci de rang i est identifié et défini comme égal à i+j si la valeur du temps de propagation calculé dti pour la cellule candidate Ci est comprise entre les valeurs de seuil prédéterminées valⱼ et valⱼ₊₁ des cellules de rangs consécutifs j et j+1, ce qui peut s'écrire sous la forme k=i+j si valⱼ<dti<valⱼ₊₁.

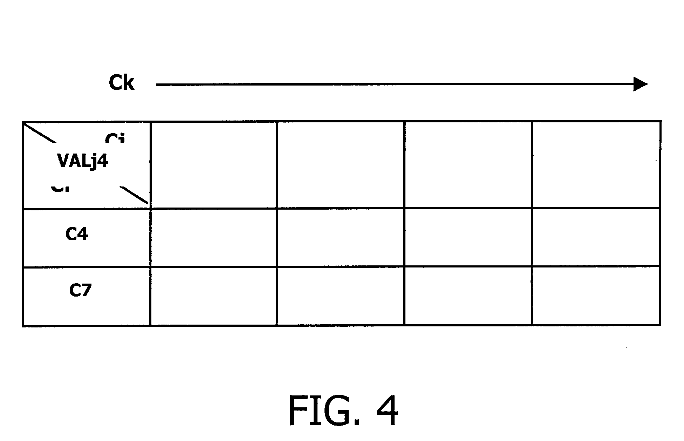

La figure 4 montre un exemple de remplacement possible selon une catégorie de cellule.
Ainsi, sur l'exemple, sont représentées 4 valeurs de seuil valj1, valj2, valj3 et valj4, et deux catégories de cellules. On a une cellule de catégorie C0 qui peut être remplacée par l'une des 4 cellules de remplacement possibles C1, C2, C3 et C4 de même catégorie selon les valeurs seuil associées. De même, on a une cellule de catégorie C1 qui peut être remplacée par l'une des 4 cellules de remplacement possibles C3, C5, C6 et C7 de même catégorie. Par exemple, si une cellule candidate de catégorie C1 a une valeur de temps de propagation dt1 supérieure à valj2 et inférieure à valj3, la cellule de rang k=3 sera C6.

Au cours d'une étape de remplacement REP, les paramètres définissant le modèle de la cellule de remplacement Ck sont extraits de la librairie LIB et substitués à ceux de la cellule candidate Ci au sein de la liste d'interconnexions NETLIST.
S'il s'agissait là de la dernière cellule candidate LCi, la liste d'interconnexions NETLIST est validée dans cet état. Dans le cas contraire, le remplacement d'une nouvelle cellule candidate Ci, identifiée au cours de l'étape d'identification ID, est soumis pour validation à l'utilisateur au cours d'une nouvelle étape de validation EN.

Pour une cellule candidate Ci à laquelle ne correspondrait pas de cellule de remplacement Ck définie dans la librairie LIB, il n'y a aucun remplacement d'effectuer. Ces cellules candidates non remplacées sont mémorisées dans un fichier. Ce fichier pourra être utilisé par la suite afin de trouver une autre solution pour résoudre le problème de ces cellules non remplacées.
Lorsque la liste d'interconnexions NETLIST aura été validée, il suffira d'exécuter l'étape de synthèse SYNTH pour obtenir un dessin Layout de la topographie du réseau de cellules optimisé dans son état définitif.
On observe que le procédé d'optimisation conforme à l'invention est simple à mettre en oeuvre et aisément maîtrisable par l'utilisateur.
A l'issue d'une unique étape d'analyse temporelle TAS, toutes les cellules présentant un temps de propagation trop élevé peuvent être remplacées, ce qui favorise la convergence sers un réseau pourvu de performances temporelles acceptables par l'utilisateur.

De plus, grâce au paramétrage possible de la valeur de référence Ref et des valeurs de seuil valⱼ par l'utilisateur, on acquiert une grande flexibilité au niveau du traitement des cellules. Selon la technologie de circuit utilisée, on paramètre les valeurs Ref et valⱼ différemment. Par exemple, pour une technologie de 0.2 microns, la valeur de référence Ref est de 0.4ns, tandis qu'on attribue, par exemple, à 4 valeurs de seuil valⱼ, les valeurs respectives de 0.4ns, 0.6ns, 0.85ns et 1ns.
De façon empirique, une bonne valeur de référence Ref peut être prise égale à la technologie utilisée pour un temps de propagation moyen. Cependant, pour prendre en compte également les temps de propagation plus grands, la valeur de référence Ref peut être préférentiellement égale à deux fois la valeur de la technologie utilisée, ce qui est le cas dans l'exemple de la technologie à 0.2microns puisqu'elle est fixée à 0.4ns.

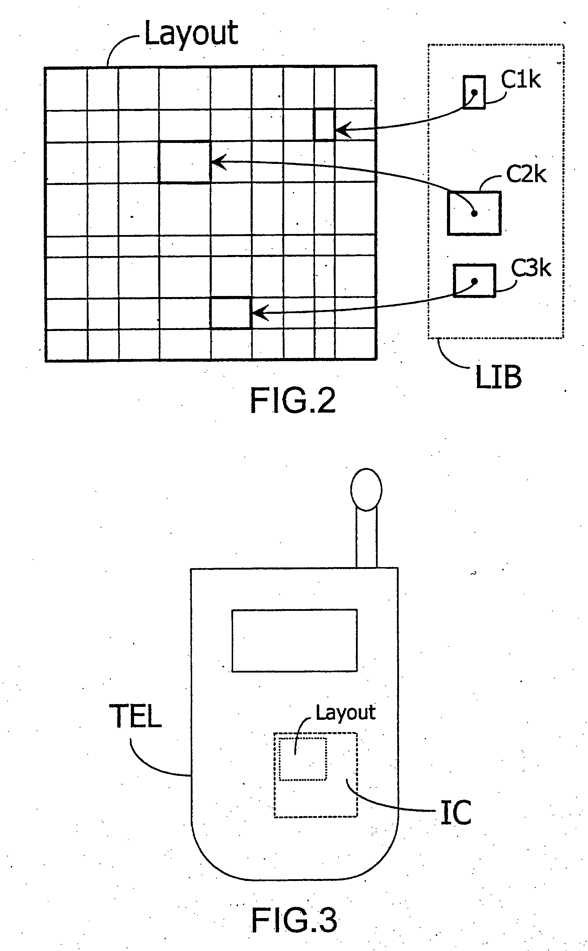

La figure 2 permet de visualiser les conséquences physiques de la mise en oeuvre du procédé d'optimisation selon l'invention. Cette figure représente schématiquement le dessin Layout de la topographie du réseau de cellules obtenue à l'issue de l'étape de synthèse. Ce réseau contient des cellules candidates au remplacement, au nombre de trois et représentées en traits gras dans cet exemple, identifiées comme telles à l'issue des étapes d'analyse temporelle, de détection et d'identification. Ces cellules seront respectivement remplacées, sous réserve de validation par l'utilisateur, par des cellules C1k, C2k et C3k de mêmes catégories mais de puissances supérieures, dont le dessin des masques sera prélevé au sein de la librairie LIB.
Bien que, pour faciliter l'identification de chaque cellule candidate au remplacement et de sa remplaçante C1k (pour I=1 à 3), lesdites cellules présentent sur la figure des dimensions identiques, il est bien entendu qu'en pratique, la surface de la cellule de remplacement C1k sera plus importante que celle de la cellule candidate au remplacement.

Bien entendu, il se peut que le remplacement d'une cellule candidate par une autre cellule influence les cellules voisines ce qui a pour conséquence de modifier le temps de propagation de la cellule calculé précédemment. Cependant cette modification est très faible et n'a pas de conséquence sur le circuit. On ne remarque pas de divergence et il n'est pas nécessaire de faire un grand nombre d'itérations dans l'analyse temporelle.

La figure 3 illustre une des nombreuses applications possibles de l'invention. Cette figure représente très schématiquement un appareil récepteur de signaux radioélectriques, ici un radiotéléphone TEL, qui inclut un circuit intégré IC, lequel comprend un réseau de cellules dont la topographie Layout a été optimisée au moyen d'un procédé d'optimisation conforme à l'invention.

## Revendications

1. Procédé d'optimisation de performances temporelles d'un réseau de cellules électroniques, comprenant une pluralité de cellules prélevées au sein d'une librairie comportant plusieurs catégories de cellules, les cellules d'une même catégorie ayant toutes une même fonctionnalité, procédé incluant les étapes suivantes :
. calcul précis de temps de propagation de signaux transitant au travers de chaque cellule du réseau, et
. identification de cellules ayant une valeur du temps de propagation calculé supérieure à une valeur de référence prédéterminée .

2. Procédé d'optimisation conforme à la revendication 1, selon lequel à chaque cellule de rang j d'une même catégorie est attribuée une valeur de seuil prédéterminée valⱼ, et selon lequel, lorsqu'une cellule de rang i identifiée doit être remplacée par une cellule de rang supérieur k, la valeur de k est au moins égale à i+j si la valeur du temps de propagation calculé pour ladite cellule de rang i est supérieure à la valeur de seuil prédéterminée valⱼ de la cellule de rang j.

3. Procédé d'optimisation conforme à la revendication 2, selon lequel, lorsqu'une cellule de rang i identifiée doit être remplacée par une cellule de rang supérieur k, la valeur de k est égale à i+j si la valeur du temps de propagation calculé pour ladite cellule de rang i est comprise entre les valeurs de seuil prédéterminées valⱼ et valⱼ₊₁ des cellules de rangs consécutifs j et j+1.

4. Procédé d'optimisation conforme à la revendication 1, selon lequel l'exécution de l'étape de remplacement est assujettie à une validation de la part d'un utilisateur dudit procédé.

5. Circuit intégré incluant un réseau de cellules dont les performances temporelles ont été optimisées au moyen d'un procédé conforme à la revendication 1.

6. Appareil récepteur de signaux radioélectriques incluant un circuit intégré conforme à la revendication 5.
